# DEMANDE DE BREVET EUROPEEN

(11) **EP 0 774 779 A1**
(43) Date de publication de la demande: **21.05.1997**
(21) Numéro de dépôt: 96402427.7
(22) Date de dépôt: 13.11.1996
(51) Int. Cl.: H01L 21/56, H01L 23/498

(54) **Procédé de fabrication d'un micromodule, notamment pour cartes à puces**

(30) Priorité: 14.11.1995 FR 9513488
(71) Demandeur: SGS-THOMSON MICROELECTRONICS S.A., 94250 Gentilly (FR)
(72) Inventeur: Steffen, Francis, 94230 Cachan (FR)
(74) Mandataire: Schmit, Christian Norbert Marie

(57) **Abrégé**

Un procédé de fabrication d'un micromodule à connecteur affleurant en surface, les plages métalliques du connecteur étant formées sur une grille support (1), comprend la formation de barrières de protection (3) entre les plages dudit connecteur de manière à former un contour fermé (cf) délimitant une zone de moulage (Z_{M}) autour de la puce en dehors d'un espace normalisé (Z_{ISO}) réservé aux connexions physiques entre le connecteur du micromodule et un système externe, pour effectuer un moulage de matière thermodurcissable ou thermoplastique autour de la puce dans cette zone de moulage délimitée.

## Description

L'invention concerne un procédé de fabrication d'un micromodule à connecteur affleurant.

On appelle micromodule, l'ensemble miniature formé principalement d'une ou plusieurs puces de circuit intégré et d'un connecteur formé de fines plages métalliques sensiblement planes. Il est destiné à être inséré dans un support d'information de faible épaisseur du type carte à puce ou clef à mémoire, en sorte que le connecteur affleure en surface du support d'information, la puce étant noyée dans le support.

Ce connecteur permet la connexion à des systèmes externes avec lequel la puce du micromodule va échanger des informations.

Des normes internationales définissent les différentes caractéristiques du micromodule et de son connecteur (normes ISO 7810 à 7816).

On connaît différents procédés de fabrication des micromodules. Un problème particulier de fabrication réside dans l'enrobage de la puce par de la résine, pour la protéger des pollutions chimiques et des contraintes mécaniques. En effet, il ne faut pas polluer la surface externe du connecteur, c'est à dire la surface qui sert à connecter physiquement le micromodule à un système externe. Quel que soit le procédé de l'art antérieur, un matériau diélectrique est utilisé avec la grille qui supporte les plages du connecteur. Ce matériau est moulé ou découpé en sorte qu'il recouvre les interstices entre les différentes plages, de manière à empêcher la résine de couler sur la face externe des plages du connecteur. Il en résulte des procédés de fabrication longs et coûteux. Notamment, pour la réalisation de micromodules en bande utilisant un procédé de report d'une bande diélectrique perforée sur une grille métallique prédécoupée, il est nécessaire d'utiliser un matériau diélectrique ayant une bonne dilatation thermique par rapport à la grille métallique, pour ne pas avoir de décalages. Il est aussi nécessaire de choisir un diélectrique utilisable sous faible épaisseur, du fait de la faible épaisseur requise pour les micromodules. Enfin il faut des appareils permettant une grande précision pour découper et caler de manière très précise la bande sur la grille. Ces procédés de fabrication ne sont pas du tout "standard" par rapport aux procédés de fabrication de circuits intégrés.

Or pour certaines applications, il est nécessaire de pouvoir fabriquer des micromodules en grande série et à un prix de revient très bas. On pense notamment aux cartes à puces prépayées jetables (par rapport aux cartes à puces rechargeables) et en particulier aux cartes téléphoniques.

L'invention a pour objet un procédé de fabrication de micromodule à connecteur affleurant.

Dans l'invention, on a cherché un procédé de fabrication fiable plus simple à mettre en oeuvre, et donc moins couteux. On a en particulier cherché une solution permettant de s'affranchir de tous les problèmes liés à l'utilisation d'un matériau diélectrique.

Une solution à ce problème technique a été trouvée dans l'invention, en considérant les caractéristiques du connecteur. Il est en effet apparu que la connexion physique du connecteur d'un micromodule avec un système externe (lecteur de cartes) ne se fait que dans une zone normalisée de connexion (norme ISO 78XX), donc parfaitement déterminée. Dans cette zone normalisée, les plages du connecteur ne doivent pas être polluées, du moins sur la face externe, pour pouvoir assurer une connexion correcte avec un appareil externe.

Dans l'invention, on s'est aperçu qu'en délimitant une zone de moulage autour de la puce en dehors de la zone normalisée de connexion physique avec un système externe, on pouvait enrober la puce par un moulage de matière thermoplastique ou thermodurcissable réalisé directement sur les plages du connecteur.

Selon l'invention, il n'est plus nécessaire d'utiliser une couche de diélectrique pour protéger les plages du connecteur pendant l'enrobage.

L'invention s'applique aux puces de faible taille, pour lesquelles les connexions aux plages du connecteur peuvent se faire dans la zone délimitée selon l'invention.

Telle que caractérisée, l'invention concerne donc un procédé de fabrication d'un micromodule à connecteur affleurant en surface, les plages métalliques du connecteur étant formées sur une grille support.

Selon l'invention, le procédé comprend la formation de barrières de protection entre les plages dudit connecteur de manière à former un contour fermé délimitant une zone de moulage autour de la puce en dehors d'un espace normalisé réservé aux connexions physiques entre le connecteur du micromodule et un système externe, pour effectuer un moulage de matière thermodurcissable ou thermoplastique autour de la puce dans cette zone de moulage délimitée.

Avantageusement, on applique une déformation aux plages du connecteur pour que les parties des plages à l'intérieur de la zone de moulage selon l'invention, soient dans un plan différent du plan de surface du connecteur du micromodule.

D'autres caractéristiques et avantages de l'invention sont donnés dans la description suivante faite à titre indicatif et non limitatif de l'invention et en référence aux dessins annexés, dans lesquels :
- la figure 1 est une vue d'une grille métallique découpée pour former un connecteur de micromodule avec plage support de la puce,
- la figure 2 représente une vue similaire pour la réalisation d'un micromodule selon l'invention, avec des barrières métalliques entre les plages pour définir un contour fermé,
- la figure 3 représente un détail de barrières et de plages d'un connecteur de micromodule, dans un mode de réalisation de l'invention,
- la figure 4 représente l'étape de moulage dans cet exemple de mise en oeuvre du procédé selon l'invention,
- la figure 5 représente un autre exemple de micromodule obtenu selon le procédé de l'invention,
- la figure 6 représente une vue de dessous partielle de la figure 5,
- la figure 7 représente un micromodule obtenu dans une variante du procédé selon l'invention, et
- les figures 8 et 9 représentent un autre mode de réalisation des barrières selon l'invention.

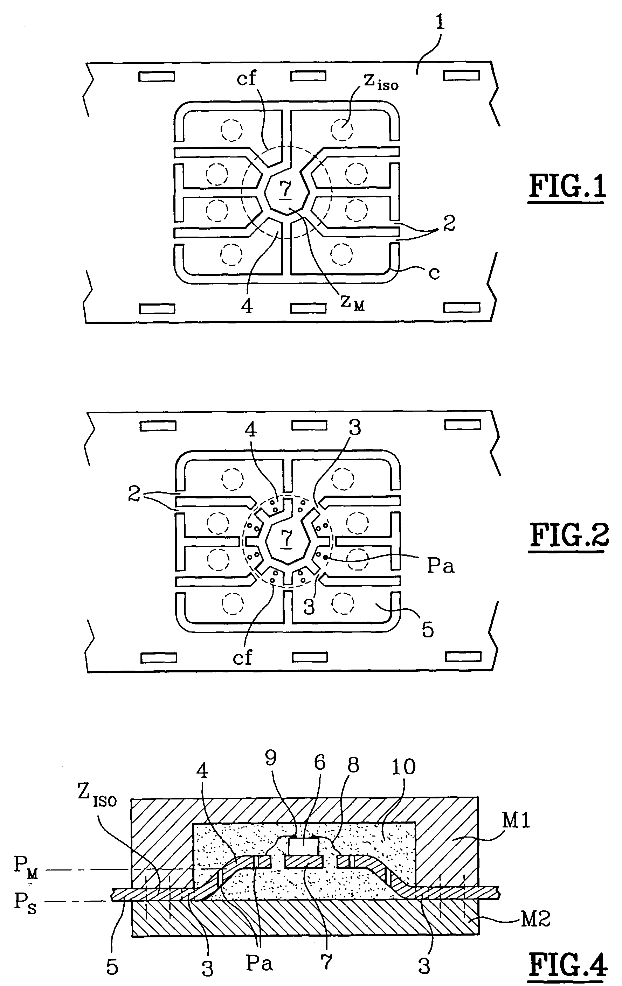

La figure 1 représente une grille support 1 d'un connecteur de micromodule. Dans l'exemple, il s'agit d'une grille métallique prédécoupée sur laquelle le connecteur qui comprend ici huit plages (c) est maintenu à la grille support par des attaches ou court-circuits 2.

Les normes internationales qui concernent les micromodules définissent en particulier une zone normalisée Z_{ISO} à l'intérieur de laquelle les contacts physiques avec un système extérieur (lecteur) doivent se faire pour chaque plage du connecteur. On peut en déduire une zone de contact normalisée zᵢₛₒ pour chaque plage de contact. Ces zones de contact normalisées sont représentées en pointillé sur le connecteur de la figure 1. Ceci permet de mettre en évidence une zone Z_{M} du connecteur à l'intérieur de laquelle ne se font pas les contacts physiques avec un système extérieur.

Selon l'invention, on peut définir matériellement cette zone Z_{M} par un contour fermé cf au moyen de barrières 3 placées entre les plages du connecteur. Ces barrières peuvent être très simplement obtenues dans l'exemple de la figure 1, dans l'opération de découpe de la grille pour former les plages du connecteur. On obtient alors une grille comme représentée sur la figure 2 : les plages restent d'une part maintenues à la grille support par les court-circuits 2 et elles sont d'autre part attachées entre elles par les barrières de protection 3 selon l'invention. Ces barrières permettent de matérialiser le contour fermé cf qui délimite la zone Z_{M} par rapport à la zone normalisée (ISO) de connexion physique. On peut alors effectuer un moulage de matière thermodurcissable ou thermoplastique sur la puce à l'intérieur de la zone délimitée par le contour fermé cf. On peut ensuite découper les barrières 3 entre les plages et les court-circuits 2 qui maintiennent les plages à la grille. On obtient un micromodule dont la partie 5 des plages du connecteur qui est à l'extérieur du contour cf et qui inclue la zone normalisée Z_{ISO} de connexion avec l'extérieur est libre. L'autre partie 4 qui est à l'intérieur du contour cf est maintenue par le moulage protégeant la puce. Dans la zone de moulage, il se peut que la résine déborde sur la face externe des plages, mais ce n'est pas gênant, puisque c'est en dehors de la zone normalisée réservée à la connexion physique avec un système externe.

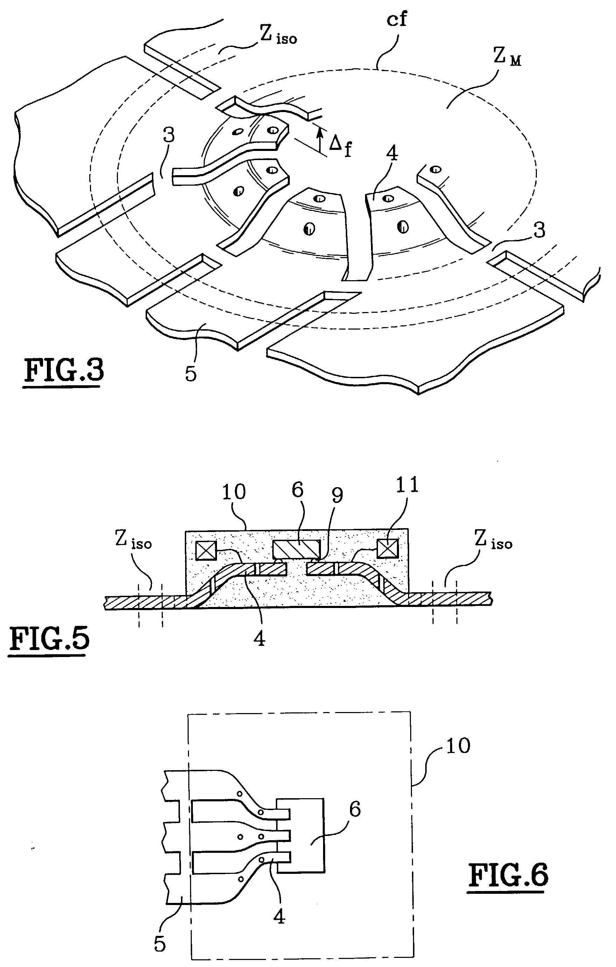

De préférence, et comme représenté sur la figure 3, on prévoit de faire subir une déformation Δf aux parties 4 des plages du connecteur situées à l'intérieur de la zone de moulage Z_{M} délimitée par les barrières 3 selon l'invention. De cette manière, ces parties 4 seront insérées dans le matériau de moulage. Cela facilitera l'accroche du matériau thermoplastique ou thermodurcissable sur les plages du connecteur. Outre cette déformation, on peut prévoir que ces parties 4 des plages de contact ont toute forme connue apte à favoriser cette accroche. Notamment, il sera judicieux de prévoir des perforations Pa dans ces parties 4, pour que la résine en passant au travers accroche bien ces parties. De telles perforations Pa ont été représentées sur les figures 2 et 3. Les autres parties 5 des plages du connecteur, situées à l'extérieur de la zone de moulage Z_{M} délimitée par les barrières 3 selon l'invention, sont libres.

Une opération de moulage selon ce procédé est représenté sur la figure 4. Le moule comprend deux parties M1 et M2. L'une , M2, comprend un fond plat qui suit le plan normal de surface externe PS du connecteur, pour venir tout contre la face externe des parties 5 des plages du connecteur. L'autre, M1, forme une cavité dans laquelle le matériau de moulage va être injecté. Les bords de la partie du moule M1 viennent s'appuyer sur la face interne des parties 5 du connecteur et jusqu'au dessus des barrières 3. De cette manière, quand le matériau thermoplastique ou thermodurcissable est injecté, il reste confiné à l'intérieur, sans déborder vers les parties 5 des plages de contact.

Dans cette exemple, on voit que la puce 6 et les parties 4 des plages de contact insérées dans le matériau moulé 10 se situent dans un plan différent P_{M} du plan normal de surface P_{S} du connecteur. Dans cet exemple, on voit que la puce a été reportée sur une plage de contact servant de plage support 7 dans une zone centrale du connecteur. Et des fils de connexion 8 ont été soudés entre les plots 9 de la puce ("*bump*" en littérature anglo-saxonne) et les parties 4 des plages de contact situées dans la zone de moulage. En d'autres termes, on a appliqué dans cet exemple le procédé de moulage selon l'invention au procédé de report automatique sur bande avec soudage par fils (technologie dite "TAB" en littérature anglo-saxonne). Le matériau moulé 10 entoure alors la puce 6, ses fils de connexion 8 et les parties 4 des plages de contact qui sont bien ancrées grâce aux perforations Pa. Les parties 5 des plages de contact à l'extérieur du contour fermé cf sont libres. Elles ne sont pas du tout polluées par l'opération de moulage.

Un autre exemple de micromodule obtenu selon le procédé de l'invention est représenté sur la figure 5. Dans cet autre exemple, on appliqué le procédé de moulage selon l'invention à un procédé de report à l'envers de la puce (procédé dit "flip-bonding" en littérature anglo-saxonne) adapté aux puces de petite taille. Dans ce procédé, la puce 6 est reportée à l'envers et ses plots 9 directement soudés sur l'extrémité des parties 4 des plages de contact, qui servent à la fois à la connexion et au support de la puce. Une vue partielle de dessous du micromodule obtenu selon l'invention est représenté sur la figure 6.

Sur la figure 5, on a intégré dans le micromodule une bobine 11 qui a pour rôle d'assurer au micromodule une double fonction de connexion : à la fois une connexion physique normalisée par les parties 5 des plages et une connexion du type "sans contact". Cette bobine pourrait tout aussi bien être prévue dans le micromodule de la figure 4. Une telle bobine peut-être prévue à l'intérieur du moulage (comme représenté). Elle est alors placée de manière à pouvoir être immobilisée par le moulage sans gêne pour la puce et ses connexions (notamment quand des fils 9 sont prévus). Quand ce n'est pas possible, elle peut-être placée à l'extérieur du moulage qui peut prévoir une forme adaptée pour la recevoir ou la centrer, tel un décroché ou une cavité, et être soudée à des plages externes 5. Dans l'exemple représenté, le fil isolant de la bobine a été enroulée autour de la puce, au niveau des parties 4, les deux extrémités soudées à ces parties 4 et la bobine a été immobilisée dans le moulage.

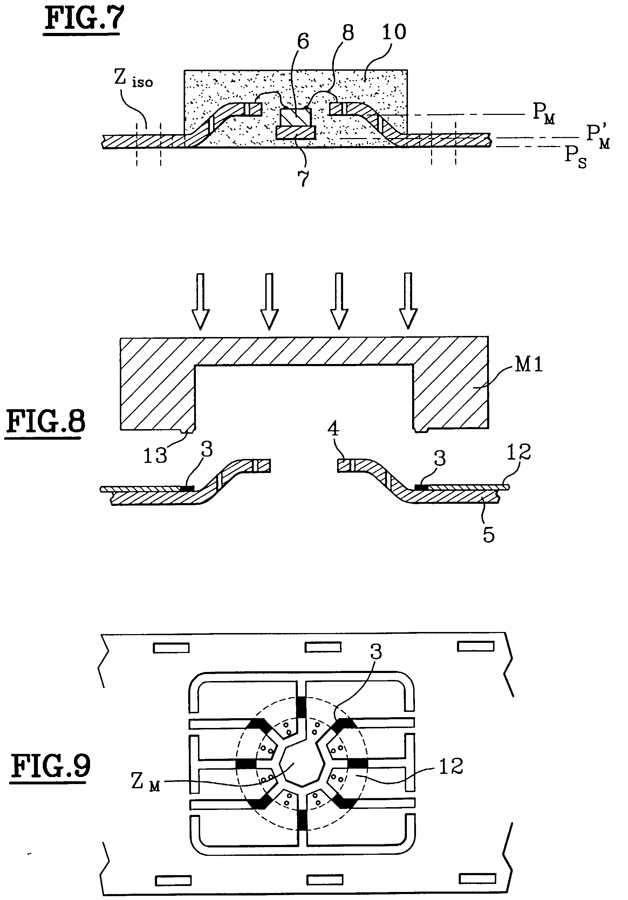

Enfin, un autre exemple de micromodule selon l'invention a été représenté sur la figure 7, pour un procédé du même type que celui décrit en relation avec la figure 4. Dans cet exemple, la partie de plage support 7 de la puce 6 est située dans un plan différent P'_{M} des autres parties 4 des plages du connecteur situées dans la zone de moulage. Ceci est notamment intéressant pour les opérations de calage et centrage sur la chaîne de fabrication. Dans l'exemple, la puce 6 est située dans un plan sous ces parties 4. Cette réalisation est particulièrement avantageuse pour réduire la hauteur du micromodule.

Les figures 8 et 9 représentent d'autres moyens pour mettre en oeuvre le procédé selon l'invention.

La figure 8 montre notamment un connecteur comme déjà décrit en relation avec la figure 1. Dans cet exemple, on utilise une forme adaptée de film diélectrique 12 préalablement déposée sur le connecteur. Cette forme de film diélectrique est évidée pour délimiter la zone Z_{M} de moulage. Le moule en venant en appui sur cette forme va lui faire épouser la forme du connecteur par compression, et donc la faire pénétrer dans les interstices entre les plages, ce qui forme les barrières 3 selon l'invention. La forme de diélectrique est une forme simple sans ajustages précis, qui ne présente donc pas les différents inconvénients de l'état de la technique. Dans des cas particuliers, elle peut couvrir largement la surface de connectique comme représenté sur la figure 9. Ceci permet de rigidifier mécaniquement les plages de contact 5. Ceci peut aussi permettre dans une certaine mesure d'agrandir la zone de moulage pour appliquer le procédé de l'invention à de plus grandes puces, sans risque de pollution des faces externes des parties 5 des plages du connecteur.

Une amélioration de ce procédé peut consister à prévoir des petites sur-épaisseurs 13 dans la forme du moule M1, de l'ordre de la dizaine de micromètres, aptes à comprimer plus fortement aux endroits où les barrières doivent être formées.

Dans le même esprit, les barrières 3 peuvent être obtenues en plaçant une forme de joint élastomère entre le moule M1 et le connecteur. Cette forme de joint souple forme le contour fermé de l'invention qui va former les barrières 3 par compression du moule : le joint élastomère épouse la forme du connecteur et pénètre dans les interstices entre les plages, ce qui va former les barrières 3 selon l'invention. C'est un procédé peu coûteux et simple à mettre en oeuvre, mais dont un inconvénient est de nécessiter un remplacement fréquent de la forme du joint.

Pour pallier cet inconvénient, cette forme de joint peut être avantageusement réalisée dans le moule en employant un élastomère approprié ( apte à tenir la température de moulage et à fluer dans les interstices). Cette forme qui est réalisée dans le moule par l'opération de moulage, peut ensuite rester dans le micromodule ainsi constitué. On n'a alors plus d'étape préalable de fabrication du joint ou de dépôt du diélectrique : tout est réalisé dans le moule, les barrières et le moulage.

Il n'est pas à exclure de réaliser les barrières selon l'invention dans la forme du moule lui-même, mais compte tenu des faibles dimensions considérées, ce procédé paraît plus difficile à mettre en oeuvre.

Tous ces exemples décrits en relation avec les figures 8 et 9 ne nécessitent pas d'opération de découpe des barrières après le moulage, ce qui est très avantageux.

L'invention qui vient d'être décrite s'étend à la fabrication de micromodules en bande (procédé de fabrication continu), les micromodules individuels étant obtenus dans une étape ultérieure de séparation.

## Revendications

1. Procédé de fabrication d'un micromodule à connecteur affleurant en surface, les plages métalliques du connecteur étant formées sur une grille support (1), caractérisé en ce qu'il comprend la formation de barrières de protection (3) entre les plages dudit connecteur de manière à former un contour fermé (cf) délimitant une zone de moulage (Z_{M}) autour de la puce en dehors d'un espace normalisé (Z_{ISO}) réservé aux connexions physiques entre le connecteur du micromodule et un système externe, pour effectuer un moulage de matière thermodurcissable ou thermoplastique autour de la puce dans cette zone de moulage délimitée.

2. Procédé de fabrication d'un micromodule selon la revendication 1, caractérisé en ce que l'on applique une déformation (Δf) aux plages dudit connecteur pour que les parties (4) de ces plages à l'intérieur de la zone de moulage (Z_{M}), soient dans un plan différent (P_{M}) du plan de surface (P_{S}) du connecteur du micromodule.

3. Procédé de fabrication d'un micromodule selon la revendication 1 ou 2, une plage du connecteur étant utilisée comme support (7) de la puce, caractérisé en ce que la plage support à l'intérieur de la zone de moulage est située dans un plan différent (P'_{M}) des autres plages du connecteur.

4. Procédé de fabrication d'un micromodule selon la revendication 3, caractérisé en ce que la plage support à l'intérieur de la zone de moulage est située dans un plan (P'_{M}) situé entre le plan (P_{M}) des autres plages du connecteur et le plan de surface (P_{S}) du connecteur.

5. Procédé de fabrication d'un micromodule selon l'une quelconque des revendications 1 à 4, caractérisé que les parties (4) des plages du connecteur situées dans la zone de moulage (Z_{M}) ont des formes favorisant l'accroche de la matière thermodurcissable ou thermoplastique.

6. Procédé de fabrication d'un micromodule selon la revendication 5, caractérisé que des parties (4) des plages du connecteur sont perforées.

7. Procédé de fabrication d'un micromodule selon l'une quelconque des revendications 1 à 6, caractérisé en ce que les barrières (3) sont métalliques et formées avec les plages du connecteur.

8. Procédé de fabrication d'un micromodule selon la revendication 7, caractérisé en ce que les barrières métalliques (3) sont découpées après l'opération de moulage.

9. Procédé de fabrication d'un micromodule selon l'une quelconque des revendications 1 à 6, caractérisé en ce que les barrières (3) sont formées dans l'opération de moulage par compression sur le connecteur d'une forme de matériau plastique isolant correspondant au contour fermé à réaliser.

10. Procédé de fabrication d'un micromodule selon la revendication 9, caractérisé en ce que ladite forme est obtenue par dépôt d'un matériau diélectrique (12) sur le connecteur préalablement au moulage.

11. Procédé de fabrication d'un micromodule selon la revendication 9, caractérisé en ce que ladite forme est un joint élastomère que l'on place dans le moule.

12. Procédé de fabrication d'un micromodule selon la revendication 9, caractérisé en ce que ladite forme est réalisée pendant l'opération de moulage à partir d'un matériau élastomère approprié.

13. Procédé de fabrication d'un micromodule selon l'une quelconque des revendications 9 à 12, caractérisé en ce que l'on prévoit des sur-épaisseurs (13) dans le moule aptes à comprimer plus fortement aux endroits où les barrières doivent être réalisées.

14. Procédé de fabrication d'un micromodule selon l'une quelconque des revendications précédentes, comprenant l'intégration d'une bobine permettant d'assurer une interface de type sans contact avec un système externe.

15. Procédé de fabrication d'un micromodule selon la revendication 14, caractérisée en ce que la bobine est prévue à l'intérieur du moulage et immobilisée par le matériau de moulage.

16. Procédé de fabrication d'un micromodule selon la revendication 14, caractérisée en ce que la bobine est prévue à l'extérieur du moulage.

17. Procédé de fabrication d'un micromodule selon la revendication 16, caractérisée en ce que le moulage a une forme appropriée pour recevoir ladite bobine.

18. Procédé de fabrication de micromodules individuels à partir d'une bande de micromodules selon l'une quelconque des revendications 1 à 17.
